# EUROPEAN PATENT APPLICATION

(11) **EP 4 687 389 A1**
(43) Date of publication of application: **04.02.2026**
(21) Application number: 25192424.7
(22) Date of filing: 29.07.2025
(51) Int. Cl.: H05K 7/20

(54) **MODULAR COOLING SYSTEM FOR PROVIDING BACKUP COOLING**

(30) Priority: 29.07.2024 US 202463676701 P
(71) Applicant: Vertiv Corporation, Westerville, OH 43082 (US)
(72) Inventor: Blaser, Colin Lewis, Westerville, 43082 (US); Breuer, Thomas Christopher, Westerville, 43082 (US); Miller, Oliver McKenzey, Westerville, 43082 (US); Raven, Matthew Alan, Westerville, 43082 (US)
(74) Representative: Cousens, Nico

(57) **Abstract**

A cooling system comprises a first closed fluid loop, a second closed fluid loop, a backup cooling storage system, and a controller. The first closed fluid loop is configured to circulate a first refrigerant and comprises a compressor, a condenser, and a first heat exchanger. The second closed fluid loop circulates a technical fluid. The technical fluid of the second closed loop is in thermal communication with the first heat exchanger. The backup cooling storage system is configured to circulate a second refrigerant selectively. The backup cooling storage system comprises a second heat exchanger, a high-pressure holding tank upstream from the second heat exchanger, a valve downstream of the high-pressure holding tank, and a low-pressure holding tank downstream from the second heat exchanger. The controller is a low-pressure holding tank and is configured to open or close the valve based on detecting a power outage in the cooling system.

## Description

### TECHNICAL FIELD

The present disclosure relates to a liquid cooling system, more specifically, to a high-density liquid backup cooling system for a data center.

### BACKGROUND

Data centers have ever-rising heat density due to the rapid increase of high-performance electronics components such as high-performance processor usage, thereby increasing the amount of heat generated and dissipated during ordinary operations. Heat removal is an important factor in computer systems and data center design, requiring thermal systems to provide increased cooling density. Various cooling systems have been used to cool data centers, particularly, electronic devices (e.g., processors, memories, networking devices, chips, and other heat-generating devices) located on a server or network rack tray. For instance, as an air cooling system, a forced convection method is used by providing a cooling airflow over the devices. In this system, fans located near the devices, fans located in computer server rooms, and/or fans located in ductwork in fluid communication with the air surrounding the electronic devices, force the cooling airflow over the tray containing the devices. However, with increasing power densities, the airflow and the corresponding power consumption can dramatically increase in an air cooling system.

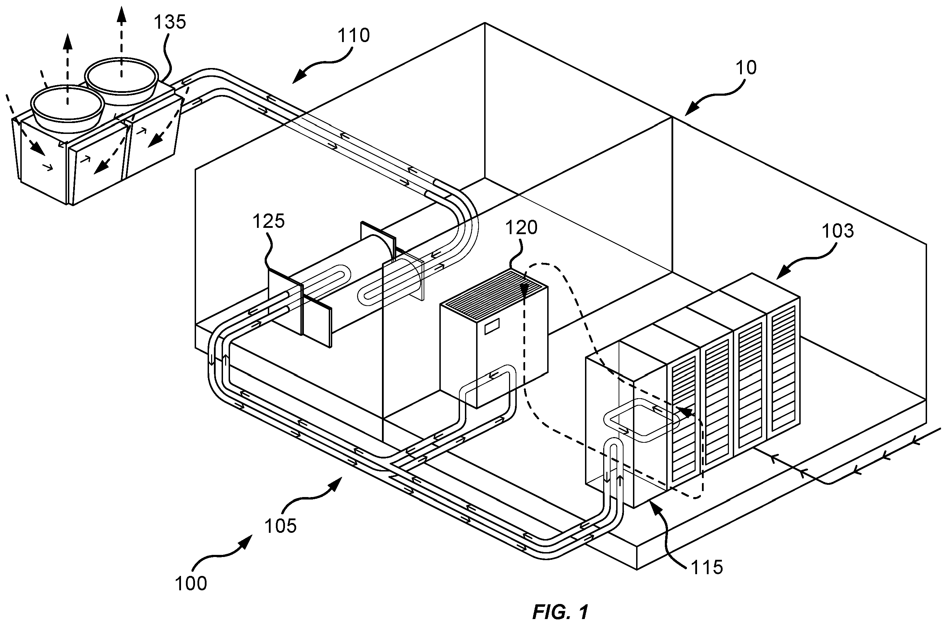

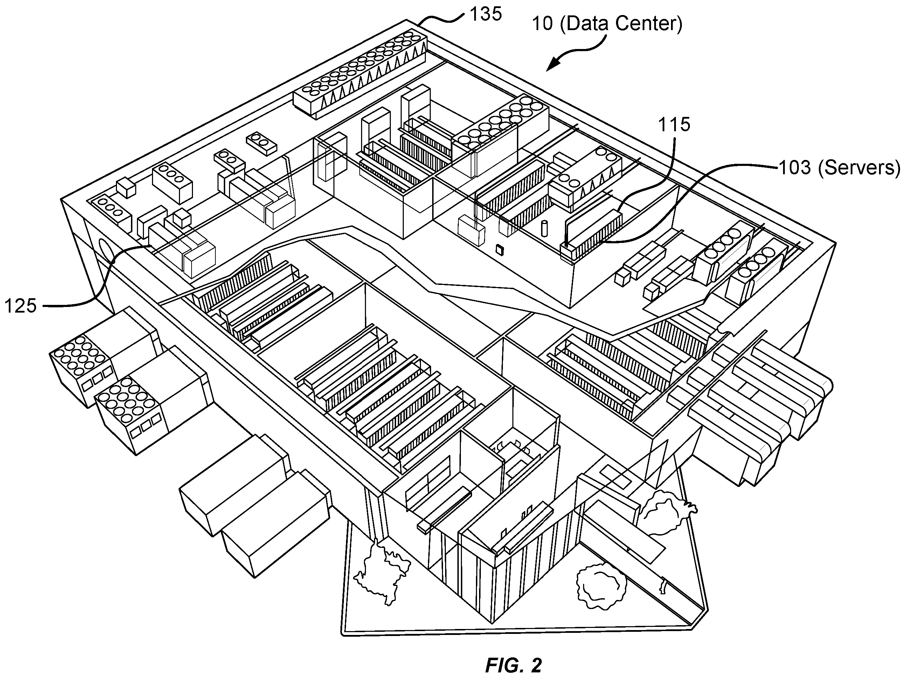

FIGS. 1 and 2 illustrate an exemplary direct-to-chip liquid cooling system 100 for use within a data center 10. The liquid cooling system 100 cools at least one heat-generating component of at least one server 103 in the data center 10. The liquid cooling system 100 includes an internal loop 105 and an external loop 110.

The internal loop 105 comprises a first working fluid and is positioned within the data center 10. The internal loop 105 further fluidly connects a coolant distribution unit (CDU) 115, a computer room air handler (CRAH) 120, and a chiller 125. The CDU 115 also receives a technical fluid loop 130, which circulates a technical fluid from the heat-generating components of one or more servers 103. In use, the CDU 115 transfers heat from the technical fluid loop to the internal loop 105. The CRAB 120 includes a liquid-to-air heat exchanger (not shown) and a fan (not shown). In use, the CRAH 120 passes air from the exhaust of the servers 103 over the liquid-to-air heat exchanger to reduce the air's temperature. The liquid in the liquid-to-air heat exchanger serves as the first working fluid in the internal loop 105.

The external loop 110 comprises a second working fluid and is partially positioned within and extends outside the data center 10. The external loop 110 fluidly connects a cooling tower 135 and the chiller 125. In use, the chiller 125 transfers heat from the first working fluid of the internal loop 105 to the second working fluid of the external loop 110. The cooling tower 135 receives the second working fluid from the chiller 125 and transfers heat accumulated in the second working fluid to the surrounding environment of the data center 10. The second working fluid has a lower temperature once it exits the cooling tower at 135 and is then sent back to the chiller at 125.

With more data centers adopting the use of such high-density liquid cooling solutions, the reduction of downtime has become critical. A great amount of time and cost are being invested into ensuring minimal downtime during power loss within data centers in order to protect their computer processing chips. In general, data center IT equipment is typically protected by uninterruptible power supplies (UPS) until generators come online following the loss of utility power. However, cooling system components such as CRAC (Computer Room Air Conditioner) or CRAH (Computer Room Air Handler) fans, chilled water pumps, and chillers (and associated cooling towers or dry coolers) are typically not connected to the UPS and may not even be connected to a genset. Consequently, data center supply air temperature may rise quickly following a power failure.

While much attention is devoted to data center cooling system design, most of that effort is aimed at improving the efficiency and reliability of its normal operation, with little attention paid to emergency operating conditions. Once there is a power failure, large amounts of heat generated by the equipment cannot be extracted and may result in a server shutdown.

In view of the foregoing, there is a need for providing backup cooling systems that can store cooling to continuously provide cooling to servers in case power outage occurs.

### SUMMARY

Embodiments described herein relate to techniques for continuously cooling data centers. In particular, systems and methods of the present disclosure provide new and novel modular cooling storage systems and methods that can be added to an existing cooling system, resulting in a solution that is not overly complex or expensive and adheres to existing standards.

Various embodiments described herein enable a simple and efficient way for data center customers to adopt high-density direct-to-chip liquid cooling with existing infrastructure. In accordance with one embodiment of the present disclosure, a modular backup cooling system having a closed fluid circuit is disclosed. The system includes: a condenser; a compressor communicating with the condenser on the closed fluid circuit; a first valve controlling fluid flowing between the condenser and the compressor; a heat exchanger; and a first tank disposed between the condenser and the heat exchanger.

In one embodiment, the present disclosure provides a cooling system that comprises a first closed fluid loop, a second closed fluid loop, a backup cooling storage system, and a controller. The first closed fluid loop circulates a first refrigerant and comprises a compressor, a condenser, and a first heat exchanger. The second closed fluid loop circulates a technical fluid. The technical fluid is in thermal communication with the first heat exchanger. The backup cooling storage system is configured to selectively circulate a second refrigerant. The back up cooling storage system comprises a second heat exchanger, a high-pressure holding tank, a valve, and a low-pressure holding tank. The second heat exchanger receives the second refrigerant. The second heat exchanger is in thermal communication with the technical fluid in the second closed fluid loop. The high-pressure holding tank upstream from the second heat exchanger stores the second refrigerant. The valve is positioned downstream of the high-pressure holding tank. The valve is configured to selectively fluidly connect the high-pressure holding tank and the second heat exchanger. The low-pressure holding tank downstream from the second heat exchanger, the low-pressure holding tank is configured to receive the second refrigerant. The controller is in electrical communication with at least the compressor and the valve. The controller is configured to open or close the valve based on detecting a power outage in the cooling system.

In another embodiment of the present disclosure, during a normal operation of the cooling system, the technical fluid of the second closed fluid loop transfers heat primarily to the first refrigerant of the first closed fluid loop via the first heat exchanger. On the other hand, if the cooling system experiences a power outage, the technical fluid of the second closed fluid loop transfers heat primarily to the second refrigerant of the backup cooling storage system via the second heat exchanger.

In another embodiment of the present disclosure, the backup cooling storage system further comprises a backup compressor. The backup compressor is powered when the second refrigerant is received in the low-pressure holding tank.

In another embodiment of the present disclosure, the cooling system further comprises a cooling distribution unit in fluid communication with the second closed fluid loop. The cooling distribution unit is in thermal communication with one or more servers.

In another embodiment of the present disclosure, the backup cooling storage system further comprises a check valve upstream of the high-pressure holding tank. The check valve is configured to limit the flow to a single direction.

In another embodiment of the present disclosure, the first heat exchanger and the second heat exchanger are brazed plate heat exchangers.

In another embodiment of the present disclosure, the low-pressure holding tank has an internal volume greater than that of the high-pressure holding tank.

In one embodiment, the present disclosure provides a backup cooling storage system in thermal communication with a closed fluid loop. The backup cooling storage system comprises a high-pressure holding tank, a heat exchanger, a solenoid valve, and a lower-pressure holding tank. The high-pressure holding tank is configured to store a refrigerant up to a first pressure. The heat exchanger positioned downstream of the high-pressure holding tank. The heat exchanger configured to receive the refrigerant from the high-pressure holding tank. The heat exchanger is in thermal communication with a technical fluid of the closed fluid loop. The solenoid valve positioned upstream of the heat exchanger and downstream of the high-pressure holding tank. The solenoid valve selectively fluidly connects the high-pressure holding tank and the heat exchanger. The low-pressure holding tank positioned downstream of the heat exchanger and is configured to receive the refrigerant at a second pressure lower than the first pressure.

In another embodiment of the present disclosure, the backup cooling storage system comprises a backup compressor, a condenser, and a check valve. The backup compressor configured to circulate a refrigerant from the low-pressure holding tank to the high-pressure holding tank. The condenser is configured to receive the refrigerant from the compressor. The condenser is positioned downstream of the compressor. The check valve is positioned downstream of the compressor and upstream of the high-pressure holding tank. The check valve is configured to limit the flow to a single direction.

In another embodiment of the present disclosure, a controller is in electrical communication with at least the solenoid valve and the backup compressor, and wherein the controller is configured to open or close the solenoid valve.

In another embodiment of the present disclosure, the refrigerant is a fluid in the high-pressure holding tank, and the refrigerant is a gas in the low-pressure fluid tank.

In one embodiment, the present disclosure provides a cooling system comprising a closed fluid loop, a cooling distribution unit, a backup cooling storage system, and a controller. The closed fluid loop is configured to circulate a technical fluid. The cooling distribution unit is in thermal communication with the technical fluid of the closed fluid loop. The backup cooling storage system comprises a high-pressure holding tank, a heat exchanger positioned downstream of the high-pressure holding tank, and a solenoid valve positioned upstream of the heat exchanger and downstream of the high-pressure holding tank. The heat exchanger selectively receives the refrigerant from the high-pressure holding tank and is in thermal communication with the technical fluid. The solenoid valve selectively fluidly connects the high-pressure holding tank and the heat exchanger. The controller in electrical communication with at least the solenoid valve and is configured to detect a power outage within the cooling system. In response to detecting a power outage within the cooling system, the controller opens the solenoid valve to fluidly connect the heat exchanger and the high-pressure holding tank.

In another embodiment of the present disclosure, during a power outage, the technical fluid of the closed fluid loop transfers heat primarily to the refrigerant of the backup cooling storage system via the heat exchanger.

In another embodiment of the present disclosure, the backup cooling storage system comprises a low-pressure holding tank positioned downstream of the heat exchanger, and a backup compressor positioned downstream of the low-pressure holding tank.

In another embodiment of the present disclosure, the compressor is powered when refrigerant is collected in the low-pressure holding tank.

Other aspects and advantages of the invention will become apparent from the following detailed description, taken in conjunction with the accompanying drawings, illustrating by way of example the principles of the invention.

### BRIEF DESCRIPTION OF THE DRAWINGS

The disclosure will be readily understood by the following detailed description in conjunction with the accompanying drawings, wherein like reference numerals designate like elements:
FIG. 1 illustrates a 3-D schematic view of a cooling system for use within a data center;
FIG. 2 illustrates a cutaway view of the cooling system for use within the data center.
FIG. 3 shows a schematic view of a modular backup cooling storage system according to embodiments of the present disclosure; and
FIG. 4 shows a schematic view of the backup cooling storage system of FIG. 3 connected to a typical liquid-cooled circuit cooling system.

### DETAILED DESCRIPTION

The figures described above and the written description of specific structures and functions below are not presented to limit the scope of what Applicant has invented or the scope of the appended claims. Rather, the Figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's goal for the commercial embodiment. Such implementation-specific decisions may include and likely are not limited to, compliance with system-related, business-related, government-related, and other constraints, which may vary by specific implementation, location, and from time to time. While a developer's efforts might be complex and time-consuming in an absolute sense, such efforts would be, nevertheless, a routine undertaking for those of skill in this art having the benefit of this disclosure. It must be understood that the inventions disclosed and taught herein are susceptible to numerous and various modifications and alternative forms.

The use of a singular term, such as, but not limited to, "a," is not intended as limiting of the number of items. The use of relational terms, such as, but not limited to, "top," "bottom," "left," "right," "upper," "lower," "down," "up," "side," and the like are used in the written description for clarity in specific reference to the Figures and are not intended to limit the scope of the inventions or the appended claims. The terms "including" and "such as" are for illustrative purposes but not limited thereto. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume, and density, among others.

The following disclosure relates to an optional addition to liquid cooling systems for maintaining cooling capacity during power loss until backup power systems can get online by maintaining a stored supply of high-pressure refrigerant in a secondary circuit that can be employed for immediate additional cooling. Data center customers are currently looking for different ways to avoid downtime in the case of loss of power within their facilities. This refrigerant loop provides on-demand cooling potential for the expected duration of a backup power source to start up. Like existing refrigerant loops, this invention contains a condenser, compressor, and Brazed plate heat exchanger (c) in addition to several different valves. Additionally, it utilizes 2 separate holding tanks. One is designed to hold and maintain a pre-determined amount of high-pressure liquid refrigerant. The second larger holding tank is to be kept empty and at a low pressure when not in use. When a power loss is detected, the solenoid valve separating these tanks will open, resulting in a pressure differential. The liquid refrigerant will flow through a BPHE to provide the backup cooling needed to maintain a low water temperature for the liquid cooled chips. Once the liquid refrigerant has all been boiled off it will collect as a gas in the low-pressure holding tank. At this point the backup power will have been activated. The compressor will turn on and send the compressed gas to the condenser before finally returning to the initial holding tank as a high-pressure liquid once more.

The proposed solutions described in this document would provide tremendous value as the risks of overheating chips and causing additional downtime due to power outages are massive. The additional security of this solution would result in more consistency for liquid cooling operations. This technology is extremely beneficial and would result in greater trust in our products and increased sales, especially in the expanding field of liquid-cooled data centers.

The term "data center" generally refers to a physical location housing one or more "servers". The term "server" generally refers to a computing device connected to a computing network and running software configured to receive requests from client computing components. Such servers may also include specialized computing components such as network routers, data acquisition equipment, movable disc drive arrays, and other components commonly associated with data centers.

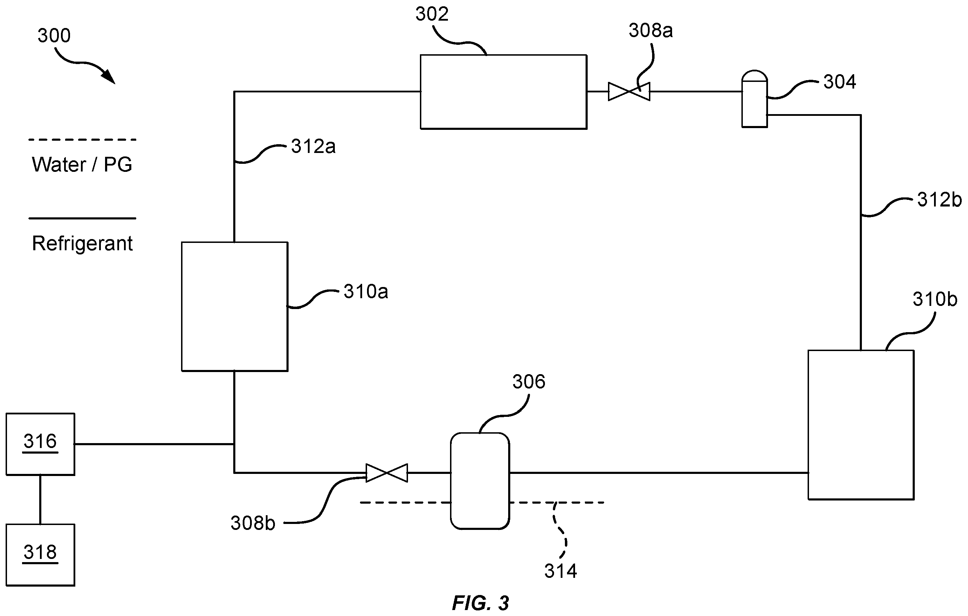

FIG. 3 shows a schematic view of a modular backup cooling storage system 300 according to embodiments of the present disclosure.

In some embodiments, the backup cooling storage system 300 includes a condenser 302, a backup compressor 304, a Brazed Plate Heat Exchanger (BPHE) 306, and one or more valves 308a, 308b. In some embodiments, the backup cooling storage system 300 further includes one or more tanks 310a, 310b. As seen in FIG. 3, the condenser 302 communicates with the first tank 310a, or more specifically, the high-pressure holding tank 310a via a first fluid channel 312a. The high-pressure holding or first tank 310a may hold a pre-determined amount of high-pressure fluid. The high-pressure may be, e.g., 400 psi or higher, depending on the amount, flowrate, volume, etc. of fluid flowing therein while the other or second tank 310b, or more specifically, the low-pressure holding tank 310b may store low-pressure fluid (e.g., less than 400 psi). In addition, the low-pressure holding tank 310b may be kept empty and at a low pressure when the system 300 is not in use.

In the present disclosure, any ASME-rated pressure vessel or tank can be used for holding the required pressure. In some embodiments, the high-pressure holding and low-pressure holding tanks 310a and 310b may be the same type of tank with different volume sizes, e.g., the high-pressure holding tank 310a may have a smaller volume. Under normal conditions, that is, when there is no power outage determined, the one or more valves 308a, 308b may be closed. For instance, a first valve 308a may be a check valve disposed between the condenser 302 and the backup compressor 304. The first valve 308a may allow a fluid to flow in only one direction so that the fluid is unable to backflow into the backup compressor 304, which could cause it to spin backward and start traveling back through the suction line during the off cycle. A second valve 308b may be a solenoid valve which can be electromechanically operated, and may be closed in the normal condition preventing communication between the tanks 310a and 310b. The operation of the first valve 308a will be described below in further detail.

In some embodiments, the fluid circulating within the system 300 may be a typical refrigerant, such as but not limited to, R22, R410A, R407C, R744, R134a, R1234yf, R290, R600a, R718, R454B, etc. Alternatively, the refrigerant can include water, glycol, etc.

The backup cooling storage system 300 may further communicate with a computing system or controller 316 and various sensors 318. The controller 316 and the various sensors 318 may be within the system 300 or installed outside and communicate with one or more elements, e.g., one or more valves 308a, 308b, of the system 300.

In some embodiments, the controller 316 may periodically or constantly communicate with the various sensors 316 detecting a real-time power status in the data center. The controller 316 may be a multiprocessor system comprising processor units. The processor units comprise multiple processor cores. The processor units can execute computer-executable programs. The computing system can comprise any number of processor units. Further, a processor unit can comprise any number of processor cores. A processor unit can take various forms such as a central processing unit (CPU), a graphics processing unit (GPU), general-purpose GPU (GPGPU), accelerated processing unit (APU), field-programmable gate array (FPGA), neural network processing unit (NPU), data processor unit (DPU), accelerator (e.g., graphics accelerator, digital signal processor (DSP), compression accelerator, artificial intelligence (AI) accelerator), controller, or other types of processing units. As such, the processor unit can be referred to as an XPU (or xPU). Further, a processor unit can comprise one or more of these various types of processing units. In some embodiments, the computing system comprises one processor unit with multiple cores, and in other embodiments, the computing system comprises a single processor unit with a single core. As used herein, the terms "processor unit" and "processing unit" can refer to any processor, processor core, component, module, engine, circuitry, or any other processing element described or referenced herein. Further, in some embodiments, the computing system can comprise one or more processor units that are heterogeneous or asymmetric to another processor unit in the computing system. There can be a variety of differences between the processing units in a system in terms of a spectrum of metrics of merit including architectural, microarchitectural, thermal, power consumption characteristics, and the like. These differences can effectively manifest themselves as asymmetry and heterogeneity among the processor units in a system.

The various sensors 318 may include, but are not limited to, an energy sensor, an OEM power sensor, a power and energy meter, a thermal power sensor, an inductive sensor, an RF sensor, etc. The various sensors 318 may further include other types of sensors, such as a temperature sensor, a humidity sensor, a pressure sensor, a displacement sensor, a voltage sensor, a current sensor, etc., communicating with the controller 316 to obtain various sensing data.

As described above, during the normal operation, the second valve 308b may be closed so that there is no fluid flowing between the tanks 310a and 310b through the BPHE 306. On the other hand, when a power loss is detected, by the sensors 318 and the controller 316, the second valve 308b separating the tanks 310a and 310b will be opened by a control of the controller 316, resulting in a pressure differential between the tanks 310a and 310b. The fluid can thus flow from the first tank 310a to the second tank 310b through the BPHE 306 to provide a backup cooling needed to maintain a low water temperature for the data center servers. Once the fluid has all been boiled off it will collect as a gas in the low-pressure holding tank 310b. At this point, the backup power would have been activated. The backup compressor 304 may then turn on and send the compressed gas to the condenser 302 before finally returning to the high-pressure holding tank 310a, which is the initial fluid holding tank, and the solenoid valve 308b may be closed.

In the present disclosure, the solenoid valve 308b can be operated by communicating with the controller 316. Solenoid valves are generally used with control elements in fluidic, and include a coil, plunger, and sleeve assembly. In normally closed valves (e.g., normal operation), a plunger return spring holds the plunger against the orifice and prevents flow. Once the solenoid coil is energized, the resultant magnetic field raises the plunger, enabling flow. When the solenoid coil is energized in a normally open valve, the plunger seals off the orifice, which in turn prevents flow. Thus, when the solenoid valve 308b is open, fluid inside the high-pressure holding tank 310b can flow to the BPHE 306 and then to the low-pressure holding tank 310b, due to the pressure difference between the tanks. The fluid flowing from the high-pressure holding tank 310a has a relatively lower temperature (e.g., cold temperature) which can then be heat-exchanged at the BPHE 306 and enters the low-pressure holding tank 310b with a higher temperature (e.g., warm or heated temperature).

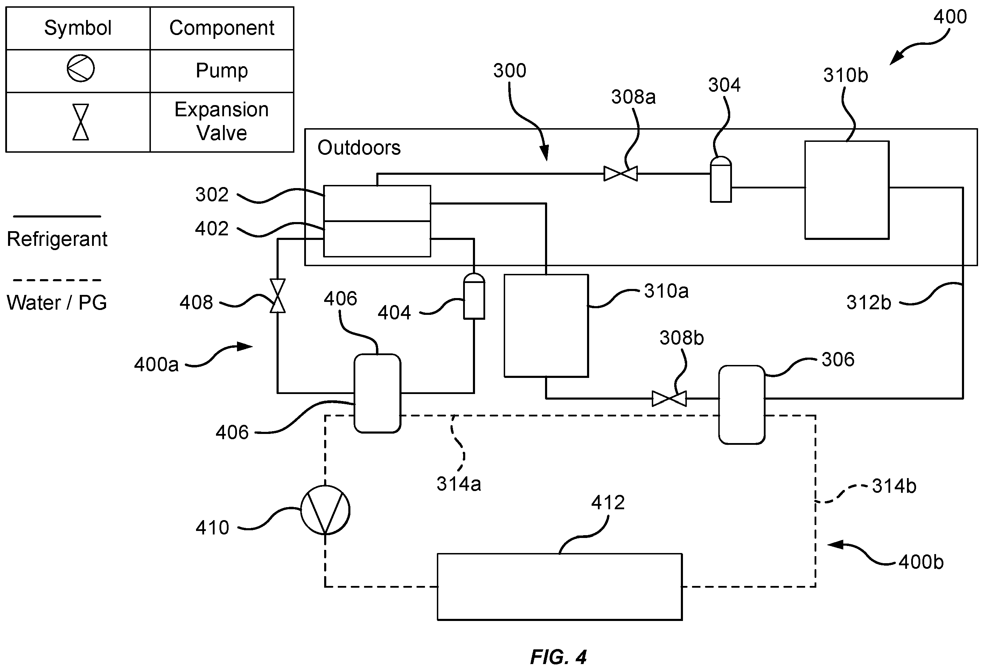

FIG. 4 shows a schematic view of the backup cooling storage system cooling system 300 of FIG. 3 implemented in an existing high-density cooling unit.

The high-density cooling unit may include a direct-expansion (DX) or first closed fluid loop 400a and a water or second closed fluid loop 400b. The DX loop 400a includes a condenser 402, a compressor 404, a BPHE 406, and an expansion valve 408. A refrigerant flowing within the DX loop 400a may be similar to the one within the backup cooling storage system cooling system 300 (or third closed fluid loop). That is, the refrigerant within the DX loop 400a may be R22, R410A, R407C, R744, R134a, R1234yf, R290, R600a, R718, R454B, water, glycol, etc. On the other hand, the water loop 400b may have a technical fluid flowing therethrough. For instance, the technical fluid may include more viscous fluids than water like ethylene glycol and water (EGW), oils, 3M Fluorinert^{®}, and Polyalphaolefin (PAO).

In some embodiments, the water loop 400b includes a pump 410 and a coolant distribution unit (CDU) 412 connected to a server rack as separate units or CDU and the server rack may be in one cabinet system. The water loop 400b communicates with the DX loop 400a via the BPHE 406 and communicates with the backup cooling storage system 300 via the BPHE 306. More specifically, the heat exchange of fluid occurs at the BPHE 306 and the BPHE 406.

During normal operation, the backup cooling storage system 300 does not operate, i.e., the solenoid valve 308b is closed and there may be little to no fluid stored in the tank 310b. Here, fluid that is heated by passing through the CDU 412 (or heated servers) can flow through a fluid line 314a to the BPHE 406 at which the temperature of the fluid can be lowered by the heat-exchange phenomenon. The cooled fluid then can be supplied back to the CDU/servers 412 by help of the pump 410.

When there is a power outage such that one of the elements, e.g., the condenser 402 doesn't operate properly and thus proper cooling can be supplied at the DX loop 400a for heat-exchanging at the BPHE 406, the solenoid valve 308b can be opened to provide high-pressure fluid having a low temperature from the tank 310a to the BPHE 306. Accordingly, the heated fluid passing on a fluid line 314b can be heat-exchanged at the BPHE 306 to lower the temperature thereof and can flow back to the CDU 412.

As shown in FIG. 4, the modular backup cooling storage system 300 may be partly installed outside the building (e.g., data center). For instance, while the condenser 302, the check valve 308a, the backup compressor 304, and the tank 310b may be installed on a rooftop of the building, the tank 310a, the valve 308b, and the BPHE 306 may be installed inside the building such that the BPHE 306 can communicate with the water loop 400b. However, this configuration is not limited what is shown in FIG. 4, such that the tank 310b may be located inside the building, etc. In addition, the condenser 302 of the system 300 and the condenser 402 of the DX loop 400a may be coupled with each other, or alternatively, integrated into one condenser unit. That is, it may be possible to reconfigure the existing condenser 402 of the DX loop 400a to connect with the modular backup cooling storage system 300. In some embodiments, the condenser 302 and the condenser 402 may be separated from each other with no contact.

The modular backup cooling storage system 300 described above implements backup cooling to computer processing chips in case of a power outage. The concept of providing contingency cooling that is effective even without power is the primary novel aspect of the present disclosure. Further, the system 300 can be implemented easily connected to an existing liquid cooling system without modification thereof and thus there is no additional cost or work to be done to the existing configuration.

Also disclosed are the following numbered clauses:
1. A cooling system comprising:
   a closed fluid loop configured to circulate a technical fluid;
   a cooling distribution unit in thermal communication with the technical fluid of the closed fluid loop;
   a backup cooling storage system comprising a high-pressure holding tank storing a
      refrigerant up to a first pressure;
      a heat exchanger positioned downstream of the high-pressure holding tank, the heat exchanger selectively receiving the refrigerant from the high-pressure holding tank, the heat exchanger is in thermal communication with the technical fluid; and
      a solenoid valve positioned upstream of the heat exchanger and downstream of the high-pressure holding tank, the solenoid valve selectively fluidly connects the high-pressure holding tank and the heat exchanger;
   a controller in electrical communication with at least the solenoid valve, the controller
      configured to detect a power outage within the cooling system;
      wherein in response to detecting a power outage within the cooling system, the controller opens the solenoid valve to fluidly connect the heat exchanger and the high-pressure holding tank.
2. The cooling system of clause 1, wherein during a power outage, the technical fluid of the closed fluid loop transfers heat primarily to the refrigerant of the backup cooling storage system via the heat exchanger.
3. The cooling system of clause 1 or 2, wherein the backup cooling storage system comprises:
   a low-pressure holding tank positioned downstream of the heat exchanger, and
   a backup compressor positioned downstream of the low-pressure holding tank.
4. The cooling system of any preceding clause, wherein the compressor is powered when refrigerant is collected in the low-pressure holding tank.
5. The backup cooling storage system of any preceding clause, wherein the refrigerant is a fluid in the high-pressure holding tank, and wherein the refrigerant is a gas in the low-pressure fluid tank.
6. The cooling system of any preceding clause, further comprising a sensor in electrical communication with the controller, and wherein the sensor is configured to communicate a sensing data to the controller.
7. The cooling system of clause 6, wherein the sensing data communicated to the controller is representative of at least one a current, a voltage, a temperature, a humidity, or a pressure.
8. The cooling system of any preceding clause, wherein the cooling distribution unit is in thermal communication with one or more servers.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

As used herein, the term "module" refers to logic that may be implemented in a hardware component or device, software or firmware running on a processor unit, or a combination thereof, to perform one or more operations consistent with the present disclosure. Software and firmware may be embodied as instructions and/or data stored on non-transitory computer-readable storage media. As used herein, the term "circuitry" can comprise, singly or in any combination, non-programmable (hardwired) circuitry, programmable circuitry such as processor units, state machine circuitry, and/or firmware that stores instructions executable by programmable circuitry. Modules described herein may, collectively or individually, be embodied as circuitry that forms a part of a computing system. Thus, any of the modules or controllers can be implemented as circuitry, such as gas pressure controller circuitry or working fluid flow rate controller circuitry. A computing system referred to as being programmed to perform a method can be programmed to perform the method via software, hardware, firmware, or combinations thereof.

Any of the disclosed methods (or a portion thereof) can be implemented as computer-executable instructions or a computer program product. Such instructions can cause a computing system or one or more processor units capable of executing computer-executable instructions to perform any of the disclosed methods. As used herein, the term "computer" refers to any computing system or device described or mentioned herein. Thus, the term "computer-executable instruction" refers to instructions that can be executed by any computing system or device described or mentioned herein.

The computer-executable instructions or computer program products as well as any data created and/or used during implementation of the disclosed technologies can be stored on one or more tangible or non-transitory computer-readable storage media, such as volatile memory (e.g., DRAM, SRAM), non-volatile memory (e.g., flash memory, chalcogenide-based phase-change non-volatile memory) optical media discs (e.g., DVDs, CDs), and magnetic storage (e.g., magnetic tape storage, hard disk drives). Computer-readable storage media can be contained in computer-readable storage devices such as solid-state drives, USB flash drives, and memory modules. Alternatively, any of the methods disclosed herein (or a portion) thereof may be performed by hardware components comprising non-programmable circuitry. In some embodiments, any of the methods herein can be performed by a combination of non-programmable hardware components and one or more processing units executing computer-executable instructions stored on computer-readable storage media.

The computer-executable instructions can be part of, for example, an operating system of the computing system, an application stored locally to the computing system, or a remote application accessible to the computing system (e.g., via a web browser). Any of the methods described herein can be performed by computer-executable instructions performed by a single computing system or by one or more networked computing systems operating in a network environment. Computer-executable instructions and updates to the computer-executable instructions can be downloaded to a computing system from a remote server.

Further, it is to be understood that implementation of the disclosed technologies is not limited to any specific computer language or program. For instance, the disclosed technologies can be implemented by software written in C++, C#, Java, Perl, Python, JavaScript, Adobe Flash, C#, assembly language, or any other programming language. Likewise, the disclosed technologies are not limited to any particular computer system or type of hardware.

Furthermore, any of the software-based embodiments (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, cable (including fiber optic cable), magnetic communications, electromagnetic communications (including RF, microwave, ultrasonic, and infrared communications), electronic communications, or other such communication means.

As used in this application and the claims, a list of items joined by the term "and/or" can mean any combination of the listed items. For example, the phrase "A, B and/or C" can mean A; B; C; A and B; A and C; B and C; or A, B and C. As used in this application and the claims, a list of items joined by the term "at least one of" can mean any combination of the listed terms. For example, the phrase "at least one of A, B or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B and C" can mean A; B; C; A and B; A and C; B and C; or A, B, and C.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present, or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods

In this application, including the definitions below, the term "module" or the term "controller" may be replaced with the term "circuit." The term "module" refers to or includes: an Application Specific Integrated Circuit (ASIC); a digital, analog, or mixed analog/digital discrete circuit; a digital, analog, or mixed analog/digital integrated circuit; a combinational logic circuit; a field programmable gate array (FPGA); a processor circuit (shared, dedicated, or group) that executes code; a memory circuit (shared, dedicated, or group) that stores code executed by the processor circuit; other suitable hardware components that provide the described functionality; or a combination of some or all of the above, such as in a system-on-chip.

The module may include one or more interface circuits. In some examples, the interface circuits may include wired or wireless interfaces that are connected to a local area network (LAN), the Internet, a wide area network (WAN), or combinations thereof. The functionality of any given module of the present disclosure may be distributed among multiple modules that are connected via interface circuits. For example, multiple modules may allow load balancing. In a further example, a server (also known as remote, or cloud) module may accomplish some functionality on behalf of a client module.

The term code, as used above, may include software, firmware, and/or microcode, and may refer to programs, routines, functions, classes, data structures, and/or objects. The term shared processor circuit encompasses a single processor circuit that executes some or all code from multiple modules. The term group processor circuit encompasses a processor circuit that, in combination with additional processor circuits, executes some or all code from one or more modules. References to multiple processor circuits encompass multiple processor circuits on discrete dies, multiple processor circuits on a single die, multiple cores of a single processor circuit, multiple threads of a single processor circuit, or a combination of the above. The term shared memory circuit encompasses a single memory circuit that stores some or all code from multiple modules. The term group memory circuit encompasses a memory circuit that, in combination with additional memories, stores some or all code from one or more modules.

The term memory circuit is a subset of the term computer-readable medium. The term computer-readable medium, as used herein, does not encompass transitory electrical or electromagnetic signals propagating through a medium (such as on a carrier wave); the term computer-readable medium may therefore be considered tangible and non-transitory. Non-limiting examples of a non-transitory, tangible computer-readable medium are nonvolatile memory circuits (such as a flash memory circuit, an erasable programmable read-only memory circuit, or a mask read-only memory circuit), volatile memory circuits (such as a static random access memory circuit or a dynamic random access memory circuit), magnetic storage media (such as an analog or digital magnetic tape or a hard disk drive), and optical storage media (such as a CD, a DVD, or a Blu-ray Disc).

The apparatuses and methods described in this application may be partially or fully implemented by a special purpose computer created by configuring a general purpose computer to execute one or more particular functions embodied in computer programs. The functional blocks, flowchart components, and other elements described above serve as software specifications, which can be translated into the computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with hardware of the special purpose computer, device drivers that interact with particular devices of the special purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

None of the elements recited in the claims are intended to be a means-plus-function element within the meaning of 35 U.S.C. § 112(f) unless an element is expressly recited using the phrase "means for," or in the case of a method claim using the phrases "operation for" or "step for."

Although the terms first, second, third, etc. may be used herein to describe various elements, pumps, condenser fans, compressors, circuits, components and/or modules, these items should not be limited by these terms. These terms may be only used to distinguish one item from another item. Terms such as "first," "second," and other numerical terms when used herein do not imply a sequence or order unless clearly indicated by the context. Thus, a first item discussed herein could be termed a second item without departing from the teachings of the example implementations.

Process flowcharts discussed herein illustrate the operation of possible implementations of systems, methods, and computer program products according to various embodiments of the present invention. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special purpose hardware and computer instructions.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

## Claims

1. A cooling system comprising:
a first closed fluid loop configured to circulate a first refrigerant, the first closed fluid loop comprising a compressor, a condenser, and a first heat exchanger;
a second closed fluid loop configured to circulate a technical fluid, the technical fluid of the second closed loop in thermal communication with the first heat exchanger;
a backup cooling storage system configured to selectively circulate a second refrigerant, the backup cooling storage system comprising:
a second heat exchanger configured to receive the second refrigerant, wherein the second heat exchanger is in thermal communication with the technical fluid in the second closed fluid loop;
a high-pressure holding tank upstream from the second heat exchanger, the high-pressure holding tank configured to store the second refrigerant;
a valve positioned downstream of the high-pressure holding tank, the valve configured to selectively fluidly connect the high-pressure holding tank and the second heat exchanger; and
a low-pressure holding tank downstream from the second heat exchanger, wherein the low-pressure holding tank is configured to receive the second refrigerant; and
a controller in electrical communication with at least the compressor and the valve, the controller configured to open or close the valve based on detecting a power outage in the cooling system.

2. The cooling system of claim 1, wherein during a normal operation, the technical fluid of the second closed fluid loop transfers heat primarily to the first refrigerant of the first closed fluid loop via the first heat exchanger, and
wherein during a power outage, the technical fluid of the second closed fluid loop transfers heat primarily to the second refrigerant of the backup cooling storage system via the second heat exchanger.

3. The cooling system of claim 1 or 2, wherein the backup cooling storage system further comprises a backup compressor, and wherein the backup compressor is powered when the second refrigerant is received in the low-pressure holding tank.

4. The cooling system of any preceding claim, further comprising a cooling distribution unit in fluid communication with the second closed fluid loop, the cooling distribution unit in thermal communication with one or more servers.

5. The cooling system of any preceding claim, wherein the backup cooling storage system further comprises a check valve upstream of the high-pressure holding tank, and wherein the check valve is configured to limit the flow to a single direction.

6. The cooling system of any preceding claim, wherein the first heat exchanger and the second heat exchanger are brazed plate heat exchangers.

7. The cooling system of any preceding claim, wherein the low-pressure holding tank has an internal volume greater than that of the high-pressure holding tank.

8. A backup cooling storage system in thermal communication with a closed fluid loop, the backup cooling storage system comprising:
a high-pressure holding tank configured to store a refrigerant up to a first pressure;
a heat exchanger positioned downstream of the high-pressure holding tank, the heat exchanger configured to receive the refrigerant from the high-pressure holding tank, wherein the heat exchanger is in thermal communication with a technical fluid of the closed fluid loop;
a solenoid valve positioned upstream of the heat exchanger and downstream of the high-pressure holding tank, wherein the solenoid valve selectively fluidly connects the high-pressure holding tank and the heat exchanger; and
a low-pressure holding tank positioned downstream of the heat exchanger, the low-pressure holding tank configured to receive the refrigerant at a second pressure lower than the first pressure.

9. The backup cooling storage system of claim 8, further comprising
a backup compressor configured to circulate a refrigerant from the low-pressure holding tank to the high-pressure holding tank;
a condenser configured to receive the refrigerant from the compressor, the condenser positioned downstream of the compressor; and
a check valve positioned downstream of the compressor and upstream of the high-pressure holding tank, wherein the check valve is configured to limit the flow to a single direction.

10. The backup cooling storage system of claim 9, wherein a controller is in electrical communication with at least the solenoid valve and the backup compressor, and wherein the controller is configured to open or close the solenoid valve

11. The backup cooling storage system of any of claims 8 to 10, wherein the low-pressure holding tank has an internal volume greater than that of the first tank.

12. The backup cooling storage system of any of claims 8 to 11, wherein the refrigerant is a fluid in the high-pressure holding tank, and wherein the refrigerant is a gas in the low-pressure fluid tank.
